(19) Europäisches Patentamt
European Patent Office
Office européen des brevets

(11) **EP 2 875 579 B1**

(12) **EUROPÄISCHE PATENTSCHRIFT**

(45) Veröffentlichungstag und Bekanntmachung des Hinweises auf die Patenterteilung:
**14.09.2016  Patentblatt 2016/37**

(21) Anmeldenummer: **13750497.3**

(22) Anmeldetag: **11.07.2013**

(51) Int Cl.:
*H02P 6/182* (2016.01)        *H02P 6/185* (2016.01)
*G01D 5/14* (2006.01)          *G01R 25/00* (2006.01)

(86) Internationale Anmeldenummer:
**PCT/EP2013/002049**

(87) Internationale Veröffentlichungsnummer:
**WO 2014/012637 (23.01.2014 Gazette 2014/04)**

(54) **VERFAHREN ZUR BESTIMMUNG DER ROTORLAGE EINES ELEKTRONISCH KOMMUTIERTEN MEHRPHASIGEN GLEICHSTROMMOTORS**

METHOD FOR DETERMINING THE ROTOR POSITION OF AN ELECTRONICALLY-COMMUTED MULTI-PHASE DIRECT CURRENT MOTOR

PROCÉDÉ DE DÉTERMINATION DE LA POSITION DU ROTOR D'UN MOTEUR À COURANT CONTINU MULTIPHASÉ À COMMUTATION ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.07.2012   DE 102012212766**

(43) Veröffentlichungstag der Anmeldung:
**27.05.2015   Patentblatt 2015/22**

(73) Patentinhaber: **Brose Fahrzeugteile GmbH&Co. Kommanditgesellschaft 97076 Wuerzburg (DE)**

(72) Erfinder: **SCHWARZKOPF, Johannes 97828 Marktheidenfeld (DE)**

(74) Vertreter: **Isarpatent
Patent- und Rechtsanwälte Behnisch Barth Charles
Hassa Peckmann & Partner mbB
Friedrichstrasse 31
80801 München (DE)**

(56) Entgegenhaltungen:
**US-A1- 2010 141 192**

**Beschreibung**

GEBIET DER ERFINDUNG

Die Erfindung betrifft ein Verfahren zur Bestimmung der Rotorlage eines elektronisch kommutierten mehrphasigen Gleichstrommotors mit Polzahl $\geq$ 2 und einem mehrsträngigen Wicklungssystem sowie einer Kommutierungsvorrichtung zur Erzeugung von Phasenspannungen in dem Wicklungssystem, wobei der Gleichstrommotor einen Rotor und einen Stator umfasst.

TECHNISCHER HINTERGRUND

Solche elektronisch kommutierten Gleichstrommotoren (BLDC-Motoren oder EC-Motoren) sind allgemein bekannt und umfassen als Rotor beispielsweise einen Permanentmagneten, der durch ein rotatorisch sich bewegendes Erregerfeld angetrieben wird. Dieses Erregerfeld wird beispielsweise von einem dreiphasigen in Stern- oder Dreieckschaltung aufgebauten Wicklungssystem erzeugt, indem dessen Wicklungsstränge mit blockförmigen oder sinusförmigen Stromverläufen bestromt werden, die zueinander phasenversetzt sind.

Die Kommutierung eines BLDC-Motors wird standardmäßig auf der Basis einer mikroprozessor- oder softwarebasierten Steuerung oder Regelung der einzelnen Phasenströme der Wicklungen des Wicklungssystems des BLDC-Motors durchgeführt, indem in bekannter Weise beispielsweise eine dreifache Halbbrücke aus Leistungsschaltern, beispielsweise MOSFETs, zur Erzeugung mehrerer in Phasenlage und Amplitude unterschiedlicher Ströme durch das Wicklungssystem benutzt wird. Die Leistungshalbleiter werden von einem Mikroprozessor angesteuert, dem zur Bestimmung der optimalen Kommutierungszeitpunkte die Rotorlage des Rotors bekannt sein muss. Die Ermittlung der Rotorposition kann sensorlos oder mit einer zusätzlichen Sensorik erfolgen.

Zur sensorlosen Ermittlung der Rotorposition des Rotors eines BLDC-Motors sind verschiedene Verfahren bekannt. Bei einer ersten Gruppe von Verfahren wird die aktuelle Rotorposition durch eine Auswertung der Nulldurchgänge der induzierten Gegenspannung (EMK) in den jeweils nicht bestromten Wicklungssträngen ermittelt, da ein in dem Wicklungssystem induzierter Spannungsvektor in eindeutiger Weise mit der Rotorposition zusammenhängt. Diese Auswertung setzt jedoch den Stillstand des Rotors voraus. Zwar lässt sich ein solches Verfahren auch bei sehr langsamer Drehung des Rotors anwenden, jedoch weist mit zunehmender Drehzahl die ermittelte Rotorlage immer größere Fehler auf.

Eine zweite Gruppe von Verfahren basiert auf der Variation der Induktivität des BLDC-Motors. Der Rotor als Permanentmagnet erzeugt eine magnetische Asymmetrie, da der magnetische Widerstand in Richtung von dessen Magnetisierung (d-Achse) größer ist als im Vergleich zu der Querrichtung (q-Achse). Daraus ergibt sich eine von der Rotorlage abhängige Induktivität des BLCD-Motors. Derjenige Wicklungsstrang des Stators, dessen magnetische Achse mit der d-Achse des Rotors zusammenfällt, weist eine minimale Induktivität auf und derjenige Wicklungsstrang, dessen magnetische Achse mit der q-Achse, d. h. um 90° verdreht, zusammenfällt, weist eine maximale Induktivität auf. Im unbestromten Zustand des BLDC-Motors besitzt der Südpol und der Nordpol des Rotors als Permanentmagnet die gleiche Wirkung, somit weist der Verlauf dieser variablen Induktivität gegenüber den elektrischen Größen die doppelte Periodizität auf. Diese 180°- Uneindeutigkeit muss für eine vollständige Lageinformation aufgelöst werden. Hierzu wird entsprechend der Richtung des Rotors ein Spannungssignal angelegt, so dass dadurch die Sättigung im Stator verringert oder verstärkt, d. h. die entsprechende Induktivität verkleinert oder vergrößert wird, so dass hieraus die Rotorlage bestimmt werden kann.

Dieser induktive Ansatz zur Bestimmung der Rotorposition ist beispielsweise aus der Druckschrift AT 395 487 B bekannt, bei dem die von Spannungsimpulsen erzeugten Stromimpulse und zugehörigen Spannungsimpulse detektiert und die sich hieraus ergebenden Induktivitäten bestimmt werden. Diese Induktivitätswerte werden einem sinusförmigen Verlauf entlang des Umfangs zugeordnet, um hieraus die aktuelle Position innerhalb des sinusförmigen Verlaufs zu ermitteln. Um die bei sich drehenden Rotor auftretende EMK-Spannung im Messergebnis kompensieren zu können, muss gemäß diesem bekannten Verfahren eine zweite Messung durchgeführt werden. Die US 2010 / 141 192 A1 offenbart ein Verfahren zur Bestimmung der Rotorlage eines bürstenlosen Gleichstrommotors, bei welchem Testspannungsimpulse erzeugt und entsprechende Ströme gemessen werden.

ZUSAMMENFASSUNG DER ERFINDUNG

Der Erfindung liegt die Aufgabe zugrunde, ein Verfahren der eingangs genannten Art anzugeben, mit welchem mit hoher Sicherheit die Rotorlage eines BLCD-Motors in allen Betriebszuständen bestimmt werden kann. Erfindungsgemäß wird ein Verfahren mit den Merkmalen des Patentanspruchs 1 vorgeschlagen.

Demgemäß ist vorgesehen:

Ein Verfahren zur Bestimmung der Rotorlage eines elektronisch kommutierten mehrphasigen Gleichstrommotors mit Polzahl $\geq 2$ und einem mehrsträngigen Wicklungssystem sowie einer Kommutierungsvorrichtung zur Erzeugung von Phasenspannungen in dem Wicklungssystem, wobei der Gleichstrommotor einen Rotor und einen Stator umfasst. Das erfindungsgemäße Verfahren zeichnet sich dabei durch folgende Verfahrensschritte aus: (a) Erzeugen von mehreren Testspannungsimpulsen in dem Wicklungssystem mit vorgegebener Einschaltdauer $\Delta T$ mittels der Kommutierungsvorrichtung in unterschiedlichen über 360° verteilten Phasenlagen; (b) Messung der Stromwerte der Stromantworten der Testspannungsimpulse mit Ablauf der Einschaltdauer der jeweiligen Testspannungsimpulse; (c) Approximation der gemessenen Stromwerte durch eine periodische Approximationsfunktion aus einer Überlagerung einer Grundwelle mit einer Amplitude $I_{EMK}$ und der dazugehörigen ersten Oberwelle mit einer Amplitude $I_{Ind}$ in Abhängigkeit der Phasenlage der Testspannungsimpulse, wobei die sinusförmige Grundwelle den zeitlichen Verlauf der Gegen-EMK-Spannung des Stators und die erste Oberwelle den zeitlichen Verlauf der Induktivität des Stators des Gleichstrommotors nachbildet; (d) Bestimmung eines Amplitudenverhältniswertes $I_{EMK}/I_{Ind}$ der Amplituden $I_{EMK}$ und $I_{Ind}$ der Grundwelle und der ersten Oberwelle der Approximationsfunktion; (e) Bestimmung der Rotorlage als EMK-Winkel aus dem Argument der Grundwelle der Approximationsfunktion und/oder als Induktivitäts-Winkel aus dem Argument der ersten Oberwelle der Approximationsfunktion in Abhängigkeit des AmplitudenVerhältnisses $I_{EMK}/I_{Ind}$, wobei der EMK-Winkel den Phasenversatz des sinusförmigen Verlaufs der Gegen-EMK-Spannung des Stators gegenüber der Approximationsfunktion und der InduktivitätsWinkel den Phasenversatz des sinusförmigen Verlaufs der Induktivität des Stators gegenüber der Approximationsfunktion angibt.

Die der vorliegenden Erfindung zugrunde liegende Erkenntnis besteht darin, dass die EMK unter anderem abhängig ist von der Geschwindigkeit und der Position des Rotors. Die Idee der vorliegenden Erfindung besteht nun darin, diese EMK nicht als Störgröße zu betrachten, sondern als Informationsgröße.

Bei diesem erfindungsgemäßen Verfahren wird daher in vorteilhafter Weise sowohl die EMK-Spannung als auch die aufgrund der magnetischen Asymmetrie des Rotors erzeugte variable Induktivität als Nutzsignal zur Bestimmung der Rotorlage des Rotors verwendet. Insbesondere bei Drehzahlen, bei welchen die Einflüsse EMK und der magnetischen Asymmetrie auf die gemessenen Stromwerte ungefähr gleich groß sind, steigt mit dem erfindungsgemäßen Verfahren die Zuverlässigkeit, die Rotorlage richtig zu bestimmen, als auch die Genauigkeit der bestimmten Rotorlage.

Es sei angemerkt, dass eine Auswertung des Einflusses der Induktivität einerseits und der EMK andererseits an sich bekannt sind. Jedoch wird bei solchen bekannten Lösungen immer nur einer der beiden Effekt betrachtet oder es wird versucht, den Einfluss des zweiten Effektes zu eliminieren oder zu minimieren. Bei der vorliegenden Erfindung tragen im Unterschied hierzu beide Effekte bei der Ermittlung der Position bei und werden infolgedessen ermittelt.

Vorteilhafte Ausgestaltungen und Weiterbildungen ergeben sich aus den weiteren Unteransprüchen sowie aus der Beschreibung unter Bezugnahme auf die Figuren der Zeichnung.

In einer vorteilhaften Ausgestaltung der Erfindung wird bei einem großen Wert A des Amplitudenverhältnisses $I_{EMK}/I_{Ind}$ mit $A \geq a_1 \gg 1$ der EMK-Winkel als Rotorlage des Rotors bestimmt. Dieses große Amplitudenverhältnis bedeutet eine große Drehzahl des Gleichstrommotors, bei welcher der Einfluss der EMK-Spannung dominiert und deshalb der Einfluss der durch die magnetische Asymmetrie des Rotors bewirkte variierende Induktivität des Motors vernachlässigbar ist. In einfacher und direkter Weise kann aus dem Argument der Grundwelle die Rotorlage des Rotors bestimmt werden.

In einer weiteren Ausgestaltung der Erfindung wird bei einem kleinen Wert A des Amplitudenverhältnisses $I_{EMK}/I_{Ind}$ mit $A \leq a_2 \ll 1$ der Induktivitäts-Winkel als Richtung des Rotors mit einer 180°-Uneindeutigkeit bestimmt. Dieser kleine Wert des Amplitudenverhältnisses tritt bei Stillstand oder bei langsamer Drehung des Rotors auf, so dass keine EMK-Spannung oder nur mit einem geringen Wert auftritt, so dass die entsprechende Amplitude der Grundwelle des Approximationsfunktion vernachlässigt werden kann und daher in einfacher Weise aus dem Argument von der ersten Oberwelle die Richtung des Rotors bestimmbar ist. Zur Beseitigung des 189°-Undeutigkeit ist in bekannter Weise eine weitere Messung durchzuführen, indem entsprechend der Richtung des Rotors ein Spannungssignal angelegt wird, so dass dadurch die Sättigung im Stator verringert oder verstärkt, d. h. die entsprechende Induktivität verkleinert oder vergrößert wird, so dass hieraus die Rotorlage bestimmt werden kann.

Eine hohe Robustheit des erfindungsgemäßen Verfahrens wird in einer besonders bevorzugten Weiterbildung der Erfindung erreicht, wenn bei einem Wert A des Amplitudenverhältnisses $I_{EMK}/I_{Ind}$ mit $a_2 < A < a_1$, wobei $a_2 \ll 1$ und $a_1 \gg 1$ ist, die Rotorlage des Rotors aus dem EMK-Winkel und/oder dem Induktivitäts-Winkel bestimmt wird. Ein solches Amplitudenverhältnis entspricht Betriebszuständen des Motors, bei dem sowohl die EMK-Spannung als auch die durch magnetische Asymmetrie des Rotors bewirkte variierende Induktivität des Motors relevanten Einfluss auf die gemessenen Stromwerte haben.

Dabei ist es gemäß einer Ausgestaltung vorteilhaft, wenn aus den gewichteten Werten des EMK-Winkels und dem Induktivität-Winkel ein Wert für die Rotorlage des Rotors bestimmt wird, wobei die Gewichtung in Abhängigkeit der Werte des EMK-Winkels und des Induktivitäts-Winkels erfolgt. Die Gewichtung kann auch in einem festen Verhältnis erfolgen. Damit wird für den gesuchten Winkel des Rotors eine hohe Genauigkeit erreicht.

Ferner ist es besonders vorteilhaft, wenn weiterbildungsgemäß die motorspezifische Phasendifferenz zwischen dem EMK-Winkel und dem Induktivitäts-Winkel bestimmt und der Wert der Phasendifferenz zur Plausibilisierung der aus dem EMK-Winkel und/oder dem Induktivitäts-Winkel bestimmten Werte für die Rotorlage des Rotors verwendet wird. Diese Phasendifferenz zwischen EMK-Winkel und dem Induktivitäts-Winkel ist für jeden Motor ein konstanter Wert und kann ermittelt werden und beträgt in der Regel entweder $+\pi/4$ oder $-\pi/4$. Dieser Wert dient dann als Indikator für den Messfehler hinsichtlich des EMK-Winkels und/oder des Induktivitäts-Winkels.

Gemäß einer weiteren Ausgestaltung der Erfindung wird bei einem Wert A des Amplitudenverhältnisses $I_{EMK}/I_{Ind}$ mit $a_2 < A < a_1$, wobei $a_2 \ll 1$ und $a_1 \gg 1$ ist, der Wert des absoluten Minimums der Approximationsfunktion als Rotorlage des Rotors verwendet, falls die motorspezifische Phasendifferenz zwischen dem EMK-Winkel und dem Induktivitäts-Winkel als $+\pi/4$ ermittelt wird. Dagegen wird weiterbildungsgemäß bei einer Phasendifferenz von $-\pi/4$ der Wert des absoluten Minimums der Approximationsfunktion als Rotorlage des Rotors verwendet. Damit ist neben einer analytischen auch eine schnelle graphische Auswertung der Approximationsfunktion möglich.

In einer weiteren vorteilhaften Ausgestaltung der Erfindung wird der Induktivitäts-Winkel in der ersten Oberwelle Approximationsfunktion durch eine Verknüpfung in Form einer Differenzbildung zwischen dem EMK-Winkel und dem InduktivitätsWinkel mit einem motor-spezifisch ermittelten Differenzwert ersetzt. Mit einer solchen erweiterten Approximationsfunktion wird ein besseres Approximationsverhalten erreicht, mit der Folge einer höheren und zuverlässigeren Bestimmung der Rotorposition des Rotors.

In einfacher und direkter Weise ergibt sich weiterbildungsgemäß aus dieser erweiterten Approximationsfunktion der die Rotorposition des Rotors darstellende EMK-Winkel aus dem Argument der Grundwelle und dem Argument der ersten Oberwelle.

In einer besonders bevorzugten Ausgestaltung wird die Approximationsfunktion aus einer Überlagerung einer sinusförmigen Grundwelle mit der Amplitude und der dazugehörigen ersten Oberwelle mit einer Amplitude in Abhängigkeit der Phasenlage $\alpha s$ der Testspannungsimpulse gebildet wird. Vorzugsweise wird die Sinus-Funktion gewählt. Die Approximationsfunktion kann aber auch davon abweichen. Z.B. wenn die EMK oder die Varianz der Induktivität nicht sinusförmig ist.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

INHALTSANGABE DER ZEICHNUNG

Die vorliegende Erfindung wird nachfolgend anhand der in den schematischen Figuren der Zeichnungen angegebenen Ausführungsbeispiele näher erläutert. Es zeigen dabei:

Figur 1     ein Schaltbild mit dem Ersatzschaltbild des Wicklungssystems eines BLCD-Motors sowie mit einer Halbbrücke und einer Kommutierungsvorrichtung zur Erläuterung des erfindungsgemäßen Verfahrens,

Figur 2     ein Schaltbild eines Zwischenkreises zur Spannungsversorgung des Wicklungssystems des BLCD-Motors nach Figur 1,

Figur 3     ein Spannungsraumzeigerdiagramm zur Darstellung von Testspannungsimpulsen gemäß des erfindungsgemäßen Verfahrens, und

Figur 4     ein Diagramm mit den der Approximationsfunktion und deren Grundwelle sowie der ersten Oberwelle entsprechenden Stromverläufen in Abhängigkeit des Rotorwinkels.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts Anderes ausführt ist - jeweils mit denselben Bezugszeichen versehen.

BESCHREIBUNG VON AUSFÜHRUNGSBEISPIELEN

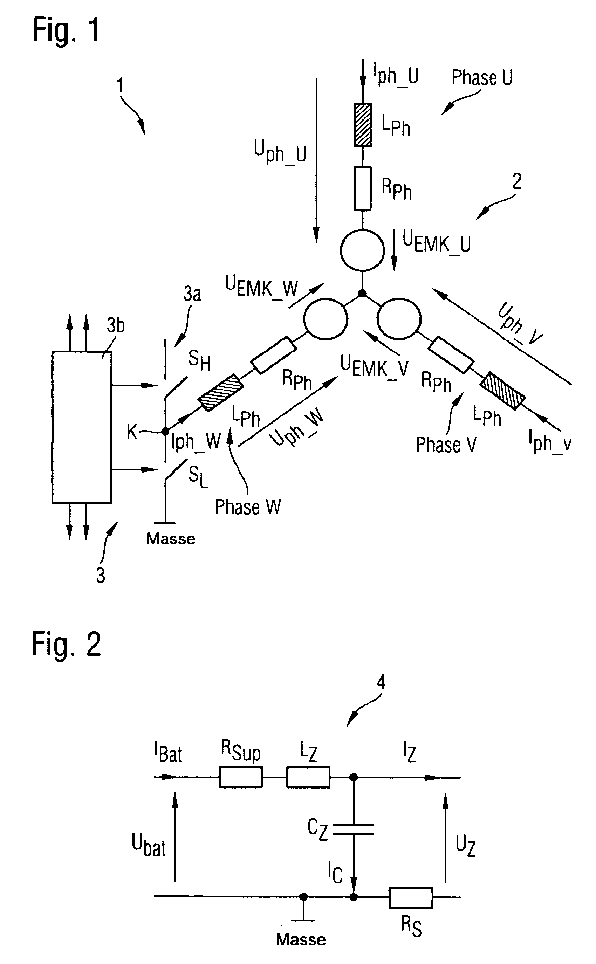

Figur 1 zeigt ein Schaltbild mit dem Ersatzschaltbild des Wicklungssystems eines BLCD-Motors sowie mit einer Halbbrücke und einer Kommutierungsvorrichtung zur Erläuterung des erfindungsgemäßen Verfahrens.

Gemäß Figur 1 wird ein 3-phasiger bürstenloser Gleichstrommotor (BLDC-Motor) 1 mit Polzahl 2, dargestellt als Wicklungssystem 2 mit in Sternschaltung geschalteten U- V- und W-Phasen von einer Kommutierungsvorrichtung 3 angetrieben. Jede der Phasen U, V und W wird von einer Halbbrücke angesteuert, wobei nur eine Halbbrücke 3a der Phase W in Figur 1 dargestellt ist. Diese Halbbrücken der Phasen U, V und W bilden zusammen mit einer Steuereinheit, beispielsweise einem Mikroprozessor 3b die Kommutierungsvorrichtung 3.

Jeder der Phasen U, V und W umfasst eine Wicklungsinduktivität $L_{Ph}$, einen Wicklungswiderstand $R_{Ph}$ sowie eine die Gegen-EMK darstellende Spannungsquelle $U_{FMK\_U}$, $U_{EMK\_V}$ bzw. $U_{EMK\_W}$.

Die Halbbrücke 3a für die Phase W und damit die Halbbrücken für die anderen Phasen U und V bestehen in bekannter Weise aus MOSFETs als Transistorschalter $S_H$ und $S_L$ und weisen jeweils Freilaufdioden (nicht dargestellt) auf. Die Phase W wird entsprechend der Darstellung nach Figur 1 an einen Phasenkontakt K der Halbbrücke 3a angeschlossen, entsprechend auch die anderen Phasen V und W an Phasenkontakte der zugehörigen Halbbrücken.

Die Halbbrücke 3a als auch die weiteren Halbbrücken werden an eine Zwischenkreisspannung $U_z$ angeschlossen, so dass der Highside-MOSFET $S_H$ auf dem Potential der Zwischenkreisspannung $U_z$ und der Lowside-MOSFET $S_L$ auf dem Bezugspotential Ground liegt.

Die Zwischenkreisspannung $U_z$ wird mittels einer an eine Batteriespannung $U_{bat}$ angeschlossenen Zwischenkreisschaltung gemäß Figur 2 erzeugt, die in einem Längszweig einen Versorgungswiderstand $R_{sup}$, eine Zwischenkreisinduktivität $L_z$ und in einem parallelen, auf einem Bezugspotential Ground liegenden Längszweig einen Shuntwiderstand $R_s$ aufweist. Ein Zwischenkreiskondensator $C_z$ verbindet die beiden Längszweige.

In Abhängigkeit der Schaltzustände der Transistorschalter der Halbbrücken wird jede Phase U, V und W entweder an das Potential der Zwischenkreisspannung $U_z$ oder auf das Bezugspotential Ground gelegt, so dass dadurch eine Phasenspannung $U_{Ph\_U}$, $U_{Ph\_V}$ bzw. $U_{Ph\_W}$ erzeugt wird, die zu einem Phasenstrom $I_{Ph\_U}$, $I_{Ph\_V}$ bzw. $I_{Ph\_W}$ führt.

Die Halbbrücke 3a der Phase U sowie die entsprechenden Halbbrücken der Phasen V und W können unabhängig voneinander folgende Zustände einnehmen:

- Zustand High:

    Der Highside-MOSFET $S_H$ ist aktiv. Die Zwischenkreisspannung liegt an der Phase U, V bzw. W.

- Zustand Low:

    Der Lowside-MOSFET $S_L$ ist aktiv. Das Bezugspotential GND liegt an der Phase U, V bzw. W.

- Zustand Tristate:

    Beide MOSFETs $S_H$ und $S_L$ sind inaktiv. Aufgrund der Wicklungsinduktivitäten $L_{Ph}$ kann Strom durch die Freilaufdioden der MOSFETs fließen. In den Phasen U, V, W wird die EMK-Spannung $U_{EMK\_U}$, $U_{EMK\_V}$ bzw. $U_{EMK\_W}$ erzeugt.

Zur Bestimmung der Rotorposition des Rotors des BLDC-Motors 1 wird dessen unterschiedliche Induktivität in Richtung der d-Achse und der hierzu senkrecht stehenden q-Achse des Rotors verwendet, wobei diese variable Induktivität ihre Ursache in der magnetischen Asymmetrie des als Stabmagneten ausgebildeten Rotors des BLDC-Motors 1 hat.

Wenn sich der Rotor in dem Stator des BLDC-Motors 1 dreht, wird eine Gegen-EMK-Spannung $U_{EMK}$ in den Phasen U, V bzw. W erzeugt. Die Varianz der Induktivität weist die doppelte Frequenz des Verlaufs der Gegen-EMK-Spannung $U_{EMK}$ auf. Die zur Bestimmung der Rotorlage durchgeführte Messung und Auswertung berücksichtigt neben der variablen Induktivität auch die Gegen-EMK-Spannung EMK. Hierzu werden Testspannungsimpulse in dem Wicklungssystem 2 des BLDC-Motors 1 erzeugt, deren Stromantworten als Stromwerte gemessen und zur Bestimmung der Rotorlage des Rotors des BLDC-Motors 1 ausgewertet werden.

Diese Testspannungsimpulse werden durch entsprechende Ansteuerung der Halbbrücke 3a der Phase W sowie der Halbbrücken der Phasen U und V der Kommutierungsvorrichtung 3 erzeugt.

Für die Halbbrücken existieren 12 Ansteuermöglichkeiten, durch die Strom in das Wicklungssystem 2 des BLDC-Motors 1 getrieben werden können. Die 12 Ansteuermöglichkeiten führen zu Spannungsvektoren, deren Richtungen in dem Wicklungssystem 2 des BLDC-Motors 1 sind um jeweils 30° gedreht und in folgender Tabelle aufgeführt.

| Nr. | Phase U | Phase V | Phase W | $\alpha_s$ [$^0$] |
|-----|---------|---------|---------|-------------------|
| 0 | Low | High | High | 0 |
| 1 | Low | Tristate | High | ~30 |
| 2 | Low | Low | High | 60 |
| 3 | Tristate | Low | High | ~90 |
| 4 | High | Low | High | 120 |
| 5 | High | Low | Tristate | ~150 |
| 6 | High | Low | Low | 180 |
| 7 | High | Tristate | Low | ~210 |
| 8 | High | High | Low | 240 |
| 9 | Tristate | High | Low | ~270 |
| 10 | Low | High | Low | 300 |
| 11 | Low | High | Tristate | ~330 |

Diese Spannungsvektoren sind von 0 bis 11 durchnummeriert, wobei der Spannungsvektor mit der Nr. 0 einen Vektor in Richtung der Phase U definiert. Die weiteren Spannungsvektoren mit den Nr. 1 bis 11 sind gegenüber dem Spannungsvektor mit der Nr. 0 um den Winkel $\alpha_s$ gedreht.

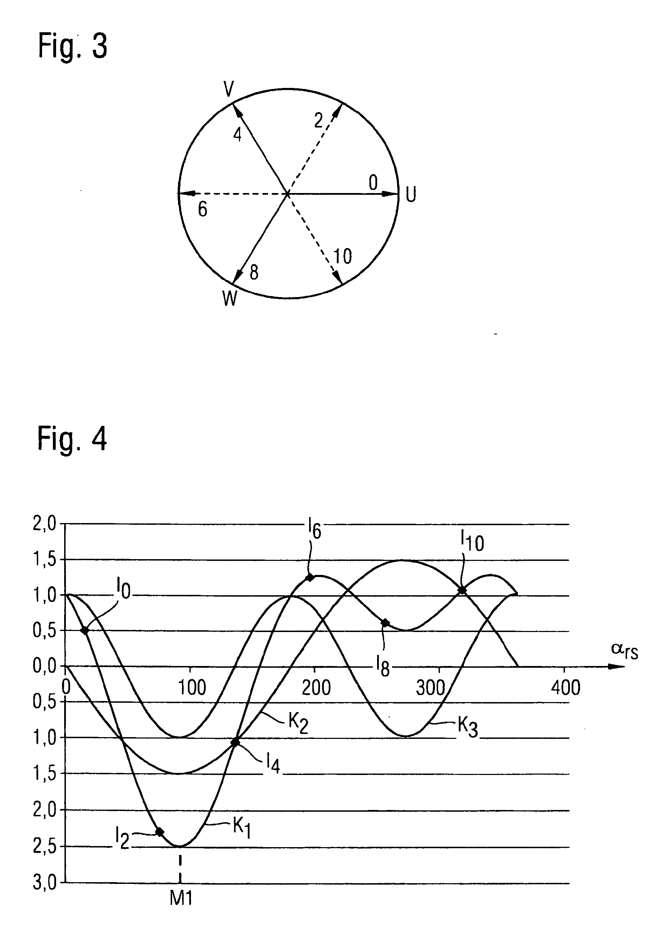

Als Testspannungsvektoren werden entsprechend dem Ansteuerschema in der Tabelle die Spannungsvektoren mit der Nr. 0 sowie mit den geradzahligen Werten der Nummern erzeugt und als Testspannungsvektoren $V_0$, $V_2$, $V_4$, $V_6$, $V_8$ und $V_{10}$ bezeichnet, die in dem Raumzeigerdiagramm gemäß Figur 3 dargestellt sind.

Die in der Tabelle aufgeführten Spannungsvektoren mit der Nr. 1, 3, 5, 7, 9 und 11 werden von einer Phase erzeugt, deren Halbbrücke den Zustand Tristate aufweist. Aufgrund der induzierten Spannung bzw. des dadurch erzeugten Freilaufstromes kann die Richtung dieser Spannungsvektoren von der theoretischen Richtung abweichen, daher sind als Winkel $\alpha_s$ dieser Spannungsvektoren in der Tabelle nur ungefähre Winkelwerte angegeben.

Mittels der Kommutierungsvorrichtung 3 werden entsprechend dem Ansteuerschema der Tabelle die Testspannungsimpulse $V_0$, $V_2$, $V_4$, $V_6$, $V_8$ und $V_{10}$ in dem Wicklungssystem 2 des BLDC-Motors 1 mit einer vorgegebenen Einschaltdauer $\Delta T$ erzeugt.

In Abhängigkeit der Testspannungsimpulse $V_0$, $V_2$, $V_4$, $V_6$, $V_8$ und $V_{10}$ werden die Stromantworten als Stromwerte $I_0$, $I_2$, $I_4$, $I_6$, $I_8$ und $I_{10}$ gemessen und stellen die Änderung $\Delta I(\alpha_s)$ des Zwischenkreisstromes $I_z$ mit $\alpha_s$ = 0°, 60°, 120°, 180°, 240° und 300° nach der Einschaltdauer $\Delta T$ dar. Die Abhängigkeit des Stromwertes $\Delta I(\alpha_s)$ von den Testspannungsimpulsen $V_0$, $V_2$, $V_4$, $V_6$, $V_8$ und $V_{10}$ wird durch den Winkel $\alpha_s$ gekennzeichnet. Im Folgenden wird für die Bezeichnung $\Delta I(\alpha_s)$ die Bezeichnung $I(\alpha_s)$ verwendet.

Aufgrund der n=6 Testspannungspulse $V_0$, $V_2$, $V_4$, $V_6$, $V_8$ und $V_{10}$ sind 6 Stromwerte $I(\alpha_s)$ , mit $\alpha_s$ = 0°, 60°, 120°, 180°, 240° und 300° ermittelt worden und sind als Messwerte $I_0$, $I_2$, $I_4$, $I_6$, $I_8$ und $I_{10}$ in dem Diagramm gemäß Figur 4 in Abhängigkeit des Winkels $\alpha_{rs}$ zwischen dem Spannungsvektor des Stators und der Rotorposition des Rotors des BLDC-Motors 1 eingetragen . Die Höhe dieser Messwerte ist hauptsächlich von der variablen Induktivität und der induzierten Gegen-EMK-Spannung abhängig.

Diese Messwerte werden nun mittels einer periodischen Approximationsfunktion $I(\alpha_s)$, die sich aus Sinus-Funktionen zusammensetzt, approximiert, wobei sich die EMK-Spannung in einer Grundwelle spiegelt und der Einfluss der variablen Induktivität mit der doppelten Frequenz der Grundwelle approximiert wird. Mit einer Näherung der Messwerte durch einen Gleichanteil $I_0$, eine Grundwelle und eine erste Oberwelle ergibt sich folgende Approximationsfunktion:

$$I(\alpha_s) = I_0 + I_{EMK} * \sin(\alpha_s - \alpha_{EMK}) + I_{Ind} * \sin(2 * (\alpha_s - \alpha_{Ind})) \qquad (1)$$

mit

$$I_{EMK} \geq 0 \; ;$$

$$I_{Ind} \geq 0 \; ;$$

$$0 \leq \alpha_{EMK} \leq 2\pi$$

$$0 \leq \alpha_{Ind} \leq 2\pi \; ,$$

wobei $I_0$ einem Gleichanteil entspricht, $\alpha_s$ der Winkel zwischen dem Testspannungsvektor $V_0$ und den jeweils anderen Testspannungsvektoren $V_2$, $V_4$, $V_6$, $V_8$ und $V_{10}$, $I_{EMK}$ und $I_{Ind}$ die Maximalamplituden der Gegen-EMK-Spannung bzw. der variablen Induktivität sind und $\alpha_{EMK}$ sowie $\alpha_{Ind}$ den Phasenversatz des sinusförmigen Verlaufs der Gegen-EMK-Spannung bzw. Phasenversatz des sinusförmigen Verlaufs der Induktivität des Stators gegenüber der Approximationsfunktion $I(\alpha_s)$ angeben und im Folgenden als EMK-Winkel $\alpha_{EMK}$ bzw. Induktivitätswinkel $\alpha_{Ind}$ bezeichnet werden.

Das Diagramm gemäß Figur 4 zeigt den Verlauf der Approximationsfunktion I($\alpha$s) als Kurve $K_1$ sowie den gegenüber der Kurve $K_1$ um den Winkel $\alpha_{EMK}$ verschobenen sinusförmigen Verlauf der Gegen-EMK-Spannung als Grundwelle, die mit $K_2$ bezeichnet ist und den gegenüber der Kurve $K_1$ um den Winkel $\alpha_{Ind}$ verschobenen Verlauf der die Induktivität nachbildenden ersten Oberwelle, die mit $K_3$ bezeichnet ist. Der Gleichanteil $I_0$ ist in Figur 4 nicht dargestellt.

Aufgrund der doppelten Frequenz der variablen Induktivität gegenüber dem Verlauf der Gegen-EMK-Spannung nimmt $\alpha_{Ind}$ bei einer Erhöhung oder Erniedrigung um den Wert $\pi$ jeweils den gleichen Wert an. Daher zeigt $\alpha_{Ind}$ nur die Richtung der d-Achse des Rotors des BLDC-Motors 1 an, das Vorzeichen ist aber zunächst nicht eindeutig (180°-Uneindeutigkeit).

Die Auswertung der Approximationsfunktion $I(\alpha_s)$ erfolgt nun in Abhängigkeit von unterschiedlichen Betriebszuständen des BLDC-Motors 1, die sich in unterschiedlichen Amplituden $I_{EMK}$ und $I_{Ind}$ der Grundwelle bzw. der ersten Oberwelle der Approximationsfunktion $I(\alpha_s)$ spiegeln. Daher wird das Amplitudenverhältniswertes $I_{EMK}/I_{Ind}$ der Amplituden $I_{EMK}$ und $I_{Ind}$ betrachtet.

Im Falle von $I_{EMK} \gg I_{Ind}$ dreht sich der BLDC-Motors 1 sehr schnell, so dass dadurch der Einfluss der Gegen-EMK-Spannung auf die gemessenen Stromwerte sehr groß und gegenüber der variablen Induktivität dominierend ist. Damit gilt für den Wert A des Amplitudenverhältniswertes $I_{EMK}/I_{Ind}$: $A \geq a_1$ mit $a_1 \gg 1$, wobei $a_1$ als Konstante motorspezifisch gewählt wird.

Damit kann in der Approximationsfunktion $I(\alpha_s)$ der Anteil der ersten Oberwelle vernachlässigt werden und der Rotorwinkel des Rotors des BLDC-Motors 1 direkt aus dem Wert des EML-Winkels $\alpha_{EMK}$ bestimmt werden.

Im Falle von $I_{EMK} \ll I_{Ind}$ befindet sich der BLDC-Motors 1 im Stillstand oder dessen Rotor dreht sich sehr langsam. Daher ist der Einfluss der Gegen-EMK-Spannung auf die gemessenen Stromwerte vernachlässigbar. Damit gilt für den Wert A des Amplitudenverhältniswertes $I_{EMK}/I_{Ind}$: $A \leq a_2$ mit $a_2 \ll 1$, wobei $a_2$ als Konstante motorspezifisch gewählt wird.

Damit kann in der Approximationsfunktion $I(\alpha_s)$ der Anteil der Grundwelle vernachlässigt werden und die Ausrichtung des Rotors der BLDC-Motors 1 bis auf die 180°- Uneindeutigkeit aus dem Wert des Induktivitäts-Winkels $\alpha_{Ind}$ bestimmt werden. Die 180°- Entscheidung muss mittels einer weiteren Messung entschieden werden, indem beispielsweise entsprechend der Richtung des Rotors ein Spannungssignal angelegt wird, so dass dadurch die Sättigung im Stator verringert oder verstärkt, d. h. die entsprechende Induktivität verkleinert oder vergrößert wird, so dass hieraus die Rotorlage bestimmt werden kann.

Dreht sich der BLDC-Motors 1 mit einer Geschwindigkeit, bei der sowohl die Gegen-EMK-Spannung als auch die variable Induktivität wesentliche Anteile der gemessenen Stromwerte darstellen, so gilt für den Wert A des Amplitudenverhältniswertes $I_{EMK}/I_{Ind}$: $a_2 < A < a_1$, wobei $a_2 \ll 1$ und $a_1 \gg 1$ ist und diese Konstanten $a_1$ und $a_2$ motorspezifisch gewählt werden.

Aus der Approximationsfunktion $I(\alpha_s)$ können damit der EMK-Winkel $\alpha_{EMK}$ und der Induktivitätswinkel $\alpha_{Ind}$ bestimmt und ausgewertet werden, d. h. die Rotorlage des Rotors wird aus dem EMK-Winkel $\alpha_{EMK}$ und dem Induktivitäts-Winkel $\alpha_{Ind}$ bzw. $\alpha_{Ind} + \pi$ wegen der 180°-Uneindeutigkeit bestimmt. Die 180°-Entscheidung kann mittels des EMK-Winkels $\alpha_{EMK}$ getroffen werden.

Durch Gewichtung dieser beiden Werte lässt sich die Rotorlage des Rotors des BLDC-Motors 1 bestimmen, wobei die Gewichtung in Abhängigkeit der Werte des EMK-Winkels $\alpha_{EMK}$ und des Induktivitäts-Winkels $\alpha_{Ind}$ erfolgt. Die Gewichtung kann auch in einem festen Verhältnis durchgeführt werden.

Eine weitere Verwendung der beiden Werte für den EMK-Winkel $\alpha_{EMK}$ und den Induktivitätswinkel $\alpha_{Ind}$ ergibt sich aus der Anwendung einer bekannten Beziehung zwischen diesen beiden Größen, die motorspezifisch, also für jeden Motor einen konstanten Wert aufweist gemäß folgender Formel:

$$\alpha_{EMK\_Ind} = \alpha_{EMK} - \alpha_{Ind}, \qquad (2)$$

wobei $\alpha_{EMK}$ den EMK-Winkel und $\alpha_{Ind}$ den Induktivitätswinkel darstellt. Der Wert dieses Winkels $\alpha_{EMK\_Ind}$ beträgt häufig $\pi/4$.

Mit dieser Beziehung (2) kann eine Plausibilisierung der beiden Werte für den EMK-Winkel $\alpha_{EMK}$ und den Induktivitätswinkel $\alpha_{Ind}$ durchgeführt werden, indem der Wert $\alpha_{EMK\_Ind}$ als Indikator für einen Messfehler dient. Weicht der Wert $\alpha_{EMK-Ind}$ zu stark von der Differenz der beiden Werte aus dem EMK-Winkel $\alpha_{EMK}$ und den Induktivitäts-Winkel $\alpha_{Ind}$ ab, so werden die Messungen, aus denen die Werte für den EMK-Winkel $\alpha_{EMK}$ und den Induktivitätswinkel $\alpha_{Ind}$ bestimmt wurde, abgelehnt.

Ein weiteres Auswerteverfahren ergibt sich unter Verwendung der Beziehung (2) . Falls dieser Winkel $\alpha_{EMK\_Ind}$ einen Wert von $+ \pi/4$ aufweist, so ist bei einem Minimum der die Grundwelle der Approximationsfunktion $I(\alpha_s)$ nachbildende Gegen-EMK-Spannung auch ein Minimum der die variable Induktivität nachbildende erste Oberwelle der Approximationsfunktion $I(\alpha_s)$ vorhanden. Beide Anteile habe die Tendenz, dieses Minimum zu verstärken, so dass es als absolutes Minimum der Approximationsfunktion $I(\alpha_s)$ bestimmbar ist. In dem Diagramm gemäß Figur 4 ist dieses absolute Minimum mit $M_1$ bezeichnet. Dieses Minimum $M_1$ entspricht als Winkel der Rotorposition des Rotors des BLDC-Motors 1.

Falls dieser Winkel $\alpha_{(EMK\_Ind}$ einen Wert von $-\pi/4$ (bzw. $3\pi/4$) aufweist, so muss anstelle des Minimums das absolute Maximum der Approximationsfunktion $I(\alpha_s)$ zur Bestimmung der Rotorlage des Rotors des BLDC-Motors 1 ermittelt werden.

Schließlich kann die Beziehung (2) auch zur Erweiterung der Approximationsfunktion $I(\alpha_s)$ gemäß (1) herangezogen werden, indem der Induktivität-Winkel $\alpha_{Ind}$ ersetzt wird durch

$$\alpha_{Ind} = \alpha_{EMK} - \alpha_{EMK\_Ind}.$$

Damit ergibt sich die erweiterte Approximationsfunktion $I(\alpha_s)$ mit einem bekannten Wert für den Winkel $\alpha_{EMK\_Ind}$ gemäß folgender Formel:

$$I(\alpha_s) = I_0 + I_{EMK} * \sin(\alpha_s - \alpha_{EMK}) + I_{Ind} * \sin(2*(\alpha_s - (\alpha_{EMK} - \alpha_{EMK\_Ind}))) \qquad (3)$$

wobei die Bedeutung der Größen denjenigen der Formel (1) und der Beziehung (2) entspricht.

Mit dieser erweiterten Approximationsfunktion $I(\alpha_s)$ gemäß der Beziehung (3) wird wieder eine Approximation der gemessenen Stromwerte $I_0$, $I_2$, $I_4$, $I_6$, $I_8$ und $I_{10}$ durchgeführt und der EMK-Winkel $\alpha_{EMK}$ bestimmt, der die Rotorposition des Rotors des BLDC-Motors 1 angibt.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar.

Bei dem oben beschriebenen Mess- und Auswerteverfahren werden die Stromantworten von mehreren Testspannungsimpulsen gemessen und ausgewertet, wobei während der Erzeugung der Testspannungsimpulse in dem Wicklungssystem des BLDC-Motors 1 und der Messung der Stromwerte die Zwischenkreisspannung konstant ist. Falls dies nicht zutrifft, müssen Spannungsschwankungen im Zwischenkreis 4 bei der Auswertung der gemessenen Stromwerte berücksichtigt werden.

In dem oben dargestellten Ausführungsbeispiel werden n=6 Testspannungsimpulse erzeugt, um hieraus mit 6 Stromwerten die Stromantworten dieser Testspannungsimpulse zu messen. Es können natürlich auch weniger als 6 oder mehr, insbesondere alle gemäß der obigen Tabelle aufgeführten 12 Spannungsvektoren (einschließlich derjenigen die mit einem Tristate-Zustand der zugehörigen Halbbrücken) zur Erzeugung der Testspannungsimpulse verwendet werden.

Ferner werden in dem oben dargestellten Ausführungsbeispiel die Stromantworten auf die Testspannungsimpulse als Stromwerte des Zwischenkreises 4, also als Zwischenkreisströme gemessen. Darüber hinaus ist es auch möglich, anstelle der Zwischenkreisströme die Phasenströme zu messen. Dann ergeben sich bei den Testspannungsimpulsen jeweils drei Messwerte für die Phasenströme $I_{ph-U}$, $I_{ph\_v}$ und $I_{ph\_W}$, wobei nur zwei Messwerte unabhängig sind. Es ist möglich, die derart erhalten Messwerte auf die Zwischenkreisströme umzurechnen oder entsprechend die Gleichungen (1) und (3) zu erweitern.

Ferner ist das beschriebene Verfahren davon unabhängig, ob das dreiphasige Wicklungssystem des BLDC-Motors 1 in einer Stern- oder Dreieckskonfiguration geschaltet ist.

Schließlich ist es natürlich auch möglich das beschriebene Verfahren zur Bestimmung der Rotorlage eines elektronisch kommutierten mehrphasigen Gleichstrommotors auch für eine Polzahl mit mehr als 2 Polen und mit einem Wicklungssystem des BLDC-Motors mit mehr als drei Wicklungssträngen durchzuführen.

Wenngleich in den vorstehenden Ausführungsbeispielen die Erfindung immer anhand von 6 Pulse dargestellt wurde, sei angemerkt, dass dies lediglich eine (z.B. bevorzugte) Variante darstellt. Es versteht sich von selbst, dass die Erfindung auch im Falle von mehr oder weniger Pulsen funktioniert.

BEZUGSZEICHENLISTE

1 Gleichstrommotor
2 Wicklungssystem des Gleichstrommotors 1
3 Kommutierungsvorrichtung
3a Halbbrücke
3b Steuereinheit, Mikroprozessor
4 Zwischenkreis

**Patentansprüche**

1. Verfahren zur Bestimmung der Rotorlage eines elektronisch kommutierten mehrphasigen Gleichstrommotors (1) mit Polzahl $\geq$ 2 und einem mehrsträngigen Wicklungssystem (2) sowie einer Kommutierungsvorrichtung (3) zur Erzeugung von Phasenspannungen ($U_{ph\_U}$, $U_{ph\_V}$ $U_{ph\_W}$) in dem Wicklungssystem (2), wobei der Gleichstrommotor (1) einen Rotor und einen Stator umfasst, **gekennzeichnet durch** folgende Verfahrensschritte:

    (a) Erzeugen von mehreren Testspannungsimpulsen ($V_0$, $V_2$, $V_4$, $V_6$, $V_8$, $V_{10}$) in dem Wicklungssystem (2) mit vorgegebener Einschaltdauer $\Delta T$ mittels der Kommutierungsvorrichtung (3) in unterschiedlichen, über 360° verteilte Phasenlagen;
    (b) Messung der Stromwerte ($I_0$, $I_2$, $I_4$, $I_6$, $I_8$, $I_{10}$) der Stromantworten der Testspannungsimpulse ($V_0$, $V_2$, $V_4$, $V_6$, $V_8$, $V_{10}$) mit Ablauf der Einschaltdauer $\Delta T$ der jeweiligen Testspannungsimpulse ($V_0$, $V_2$, $V_4$, $V_6$, $V_8$, $V_{10}$) ;
    (c) Approximation der gemessenen Stromwerte ($I_0$, $I_2$, $I_4$, $I_6$, $I_8$, $I_{10}$) **durch** eine periodische Approximationsfunktion $I(\alpha_s)$ aus einer Überlagerung einer Grundwelle mit einer Amplitude $I_{EMK}$ und der dazugehörigen ersten Oberwelle mit einer Amplitude $I_{Ind}$ in Abhängigkeit der Phasenlage $\alpha_s$ der Testspannungsimpulse ($V_0$, $V_2$, $V_4$, $V_6$, $V_8$, $V_{10}$), wobei die Grundwelle den zeitlichen Verlauf der Gegen-EMK-Spannung des Stators und die erste Oberwelle den zeitlichen Verlauf der Induktivität des Stators des Gleichstrommotors (1) nachbildet;
    (d) Bestimmung eines Amplitudenverhältniswertes $I_{EMK}/I_{Ind}$ der Amplituden $I_{EMK}$ und $I_{Ind}$ der Grundwelle und der ersten Oberwelle der Approximationsfunktion $I(\alpha_s)$;
    (e) Bestimmung der Rotorlage als EMK-Winkel $\alpha_{EMK}$ aus dem Argument ($\alpha_s$-$\alpha_{EMK}$) der Grundwelle der Approximationsfunktion $I(\alpha_s)$ und/oder als Induktivitäts-Winkel $\alpha_{Ind}$ aus dem Argument der ersten Oberwelle der Approximationsfunktion $I(\alpha_s)$ in Abhängigkeit des Amplitudenverhältnisses $I_{EMK}/I_{Ind}$, wobei der EMK-Winkel $\alpha_{EMK}$ den Phasenversatz des sinusförmigen Verlaufs der Gegen-EMK-Spannung des Stators gegenüber der Approximationsfunktion $I(\alpha_s)$ und der Induktivitäts-Winkel $\alpha_{Ind}$ den Phasenversatz des sinusförmigen Verlaufs der Induktivität des Stators gegenüber der Approximationsfunktion $I(\alpha_s)$ angibt.

2. Verfahren nach Anspruch 1,
    **dadurch gekennzeichnet,**
    **dass** bei einem großen Wert A des Amplitudenverhältnisses $I_{EMK}/I_{Ind}$ mit A$\geq$a$_1$ » 1 der EMK-Winkel $\alpha_{EMK}$ als Rotorlage des Rotors bestimmt wird.

3. Verfahren nach einem der vorhergehenden Ansprüche,
    **dadurch gekennzeichnet,**
    **dass** bei einem kleinen Wert A des Amplitudenverhältnisses $I_{EMK}/I_{Imd}$ mit A$\leq$a$_2$ « 1 der Induktivitäts-Winkel $\alpha_{Ind}$ als Richtung des Rotors mit einer 180°-Uneindeutigkeit bestimmt wird.

4. Verfahren nach einem der vorhergehenden Ansprüche,
    **dadurch gekennzeichnet,**
    **dass** bei einem Wert A des Amplitudenverhältnisses $I_{EMK}/I_{Ind}$ Mit a$_2$ < A < a$_1$, wobei a$_2$ « 1 und a$_1$ » 1 ist, die

Rotorlage des Rotors aus dem EMK-Winkel $\alpha_{EMK}$ und/oder dem Induktivitäts-Winkel $\alpha_{Ind}$ bestimmt wird.

5. Verfahren nach Anspruch 4,
   **dadurch gekennzeichnet,**
   **dass** aus den gewichteten Werten des EMK-Winkels $\alpha_{EMK}$ und dem Induktivität-Winkel $\alpha_{Ind}$ ein Wert für die Rotorlage des Rotors bestimmt wird, wobei die Gewichtung in Abhängigkeit des Werte des EMK-Winkels $\alpha_{EMK}$ und des Induktivitäts-Winkels $\alpha_{Ind}$ erfolgt.

6. Verfahren nach Anspruch 4,
   **dadurch gekennzeichnet,**
   **dass** die motorspezifische Phasendifferenz $\alpha_{EMK\_Ind}$ zwischen dem EMK-Winkel $\alpha_{EMK}$ und dem Induktivitäts-Winkel $\alpha_{Ind}$ bestimmt wird und der Wert der Phasendifferenz $\alpha_{EMK\_Ind}$ zur Plausibilisierung der aus dem EMK-Winkel $\alpha_{EMK}$ und/oder dem Induktivitäts-Winkel $\alpha_{Ind}$ bestimmten Werte für die Rotorlage des Rotors verwendet wird.

7. Verfahren nach einem der Ansprüche 1 bis 3,
   **dadurch gekennzeichnet,**
   **dass** bei einem Wert A des Amplitudenverhältnisses $I_{EMK}/I_{Ind}$ mit $a_2 < A < a_1$, wobei $a_2 \ll 1$ und $a_1 \gg 1$ ist, der Wert des absoluten Minimums ($M_1$) der Approximationsfunktion $I(\alpha_s)$ als Rotorlage des Rotors verwendet wird, falls die motorspezifische Phasendifferenz $\alpha_{EMK\_Ind}$ zwischen dem EMK-Winkel $\alpha_{EMK}$ und dem Induktivitäts-Winkel $\alpha_{Ind}$ als $+\pi/4$ ermittelt wird.

8. Verfahren nach einem der Ansprüche 1 bis 3,
   **dadurch gekennzeichnet,**
   **dass** bei einem Wert A des Amplitudenverhältnisses $I_{EMK}/I_{Ind}$ mit $a_2 < A < a_1$, wobei $a_2 \ll 1$ und $a_1 \gg 1$ ist, die Rotorlage des Rotors als den Wert des absoluten Minimums der Approximationsfunktion $I(\alpha_s)$ verwendet wird, falls die motorspezifische Phasendifferenz $\alpha_{EMK\_Ind}$ zwischen dem EMK-Winkel $\alpha_{EMK}$ und dem Induktivitäts-Winkel $\alpha_{Ind}$ als $-\pi/4$ ermittelt wird.

9. Verfahren nach einem der vorhergehenden Ansprüche,
   **dadurch gekennzeichnet,**
   **dass** der Induktivitäts-Winkel $\alpha_{Ind}$ in der Approximationsfunktion $I(\alpha_s)$ durch eine Verknüpfung in Form einer Differenzbildung zwischen dem EMK-Winkel $\alpha_{EMK}$ und dem Induktivitäts-Winkel $\alpha_{Ind}$ mit einem motorspezifisch ermittelten Differenzwert $\alpha_{EMK\_Ind}$ ersetzt wird.

10. Verfahren nach Anspruch 9,
    **dadurch gekennzeichnet,**
    **dass** der EMK-Winkel $\alpha_{EMK}$ aus dem Argument der Grundwelle und dem Argument der ersten Oberwelle als Rotorposition bestimmt wird.

11. Verfahren nach einem der vorherigen Ansprüche,
    **dadurch gekennzeichnet,**
    **dass** die Approximationsfunktion $I(\alpha_s)$ aus einer Überlagerung einer sinusförmigen Grundwelle mit der Amplitude IEMK und der dazugehörigen ersten Oberwelle mit einer Amplitude IInd in Abhängigkeit der Phasenlage $\alpha_s$ der Testspannungsimpulse (V0, V2, V4, V6, V8, V10) gebildet wird.

**Claims**

1. Method for determining the rotor position of an electronically commutated multi-phase DC motor (1) having a pole number $\geq 2$ and a multi-strand winding system (2) and also a commutating device (3) for generating phase voltages ($U_{ph\_u}$, $U_{ph\_v}$, $U_{ph\_w}$) in the winding system (2), wherein the DC motor (1) comprises a rotor and a stator, **characterized by** the following method steps:

   (a) generating multiple test voltage pulses ($V_0$, $V_2$, $V_4$, $V_6$, $V_8$, $V_{10}$) in the winding system (2) with a predetermined duty cycle $\Delta T$ by means of the commutating device (3) in different phase positions that are distributed over 360°;
   (b) measuring the current values ($I_0$, $I_2$, $I_4$, $I_6$, $I_8$, $I_{10}$) of the current responses to the test voltage pulses ($V_0$, $V_2$, $V_4$, $V_6$, $V_8$, $V_{10}$) with the expiry of the duty cycle $\Delta T$ of the respective test voltage pulses ($V_0$, $V_2$, $V_4$, $V_6$, $V_8$, $V_{10}$);
   (c) approximating the measured current values ($I_0$, $I_2$, $I_4$, $I_6$, $I_8$, $I_{10}$) by means of a periodic function approximation

$I(\alpha_s)$ from the superposition of a fundamental wave that has an amplitude $I_{EMF}$ and the superposition of the associated first harmonic wave that has an amplitude $I_{Ind}$ in dependence upon the phase position $\alpha_s$ of the test voltage pulses $V_0$, $V_2$, $V_4$, $V_6$, $V_8$, $V_{10}$), wherein the fundamental wave emulates the temporal progression of the back-EMF voltage of the stator and the first harmonic wave emulates the temporal progression of the inductance of the stator of the DC motor (1);

(d) determining an amplitude ratio value $I_{EMF}/I_{Ind}$ of the amplitudes $I_{EMF}$ and $I_{Ind}$ of the fundamental wave and of the first harmonic wave of the function approximation $I(\alpha_s)$;

(e) determining the rotor position as an EMF angle $\alpha_{EMF}$ from the argument ($\alpha s - \alpha_{EMF}$) of the fundamental wave of the function approximation $I(\alpha_s)$ and/or as an inductance angle $\alpha_{Ind}$ from the argument of the first harmonic wave of the function approximation $I(\alpha_s)$ in dependence upon the amplitude ratio $I_{EMF}/I_{Ind}$, wherein the EMF angle $\alpha_{EMF}$ indicates the phase offset of the sinusoidal progression of the back-EMF voltage of the stator with respect to the function approximation $I(\alpha_s)$ and the inductance angle $\alpha_{Ind}$ indicates the phase offset of the sinusoidal progression of the inductance of the stator with respect to the function approximation $I(\alpha_s)$.

2. Method as claimed in claim 1,
   **characterized in**
   **that** in the case of a high value A of the amplitude ratio $I_{EMF}/I_{Ind}$ with $A \geq a_1 \gg 1$ the EMF angle $\alpha_{EMF}$ is determined as the rotor position of the rotor.

3. Method as claimed in any one of the preceding claims,
   **characterized in**
   **that** in the case of a low value A of the amplitude ratio $I_{EMF}/I_{Ind}$ with $A \leq a_2 \ll 1$ the inductance angle $\alpha_{Ind}$ is determined as the direction of the rotor with a 180° ambiguity.

4. Method as claimed in any one of the preceding claims,

   **characterized in**
   **that** in the case of a value A of the amplitude ratio $I_{EMF}/I_{Ind}$ with $a_2 < A < a_1$, wherein $a_2 \ll 1$ and $a_1 \gg 1$, the rotor position of the rotor is determined from the EMF angle $\alpha_{EMF}$ and/or the inductance angle $\alpha_{Ind}$.

5. Method as claimed in claim 4,
   **characterized in**
   **that** a value for the rotor position of the rotor is determined from the weighted values of the EMF angle $\alpha_{EMF}$ and the inductance angle $\alpha_{Ind}$, wherein the weighting is performed in dependence upon the values of the EMF angle $\alpha_{EMF}$ and the inductance angle $\alpha_{Ind}$.

6. Method as claimed in claim 4,
   **characterized in**
   **that** the motor-specific phase difference $\alpha_{EMF\_Ind}$ between the EMF angle $\alpha_{EMF}$ and the inductance angle $\alpha_{Ind}$ is determined and the value of the phase difference $\alpha_{EMF\_Ind}$ is used for the plausibility check on the values for the rotor position of the rotor, said values being determined from the EMF angle $\alpha_{EMF}$ and/or the inductance angle $\alpha_{Ind}$.

7. Method as claimed in any one of claims 1 to 3,
   **characterized in**
   **that** in the case of a value A of the amplitude ratio $I_{EMF}/I_{Ind}$ with $a_2 < A < a_1$, wherein $a_2 \ll 1$ and $a_1 \gg 1$, the value of the absolute minimum ($M_1$) of the function approximation $I(\alpha_s)$ is used as a rotor position of the rotor if the motor specific phase difference $\alpha_{EMF\_Ind}$ between the EMF angle $\alpha_{EMF}$ and the inductance angle $\alpha_{Ind}$ is ascertained as $+\pi/4$.

8. Method as claimed in any one of claims 1 to 3,
   **characterized in that**
   that in the case of a value A of the amplitude ratio $I_{EMF}/I_{Ind}$ with $a_2 < A < a_1$, wherein $a_2 \ll 1$ and $a_1 \gg 1$, the rotor position of the rotor is used as the value of the absolute minimum of the function approximation $I(\alpha_s)$ if the motor specific phase difference $\alpha_{EMF\_Ind}$ between the EMF angle $\alpha_{EMF}$ and the inductance angle $\alpha_{Ind}$ is ascertained as $-\pi/4$.

9. Method as claimed in any one of the preceding claims,
   **characterized in**
   **that** the inductance angle $\alpha_{Ind}$ is replaced in the function approximation $I(\alpha_s)$ by means of a correlation in the form of establishing the difference between the EMF angle $\alpha_{EMF}$ and the inductance angle $\alpha_{Ind}$ with a motor specifically

ascertained difference value $\alpha_{EMF\_Ind}$.

10. Method as claimed in claim 9,
**characterized in**
**that** the EMF angle $\alpha_{EMF}$ is determined from the argument of the fundamental wave and the argument of the first harmonic wave as a rotor position.

11. Method as claimed in any one of the preceding claims,
**characterized in**
**that** the function approximation $I(\alpha_s)$ is formed from the superposition of a sinusoidal fundamental wave that has the amplitude $I_{EMF}$ and the superimposition of the associated first harmonic wave that has an amplitude $I_{Ind}$ in dependence upon the phase position as of the test voltage pulse ($V_0$, $V_2$, $V_4$, $V_6$, $V_8$, $V_{10}$).

**Revendications**

1. Procédé de détermination de la position du rotor d'un moteur à courant continu multiphasé à commutation électronique (1) doté d'un nombre de pôles ≥ 2 et d'un système d'enroulement multifilaire (2) ainsi que d'un dispositif de commutation (3) destiné à générer des tensions simples ($U_{ph\_U}$, $U_{ph\_V}$, $U_{ph\_W}$) dans le système d'enroulement (2), le moteur à courant continu (1) comprenant un rotor et un stator, **caractérisé par** les étapes de procédé suivantes :

   (a) génération de plusieurs impulsions de tension de test ($V_0$, $V_2$, $V_4$, $V_6$, $V_8$, $V_{10}$) dans le système d'enroulement (2) avec une durée de mise sous tension $\Delta T$ au moyen du dispositif de commutation (3) dans des positions de phase différentes réparties sur 360° ;
   (b) mesure des valeurs de courant ($I_0$, $I_2$, $I_4$, $I_6$, $I_8$, $I_{10}$) des réponses de courant aux impulsions de tension de test ($V_0$, $V_2$, $V_4$, $V_6$, $V_8$, $V_{10}$) à l'écoulement de la durée de mise sous tension $\Delta T$ des impulsions de tension de test ($V_0$, $V_2$, $V_4$, $V_6$, $V_8$, $V_{10}$) respectives ;
   (c) approximation des valeurs de courant ($I_0$, $I_2$, $I_4$, $I_6$, $I_8$, $I_{10}$) mesurées par une fonction d'approximation périodique $I(\alpha_s)$ constituée d'une superposition d'une onde fondamentale avec une amplitude $I_{EMK}$ et de la première onde harmonique associée avec une amplitude $I_{Ind}$ en fonction de la position de phase $\alpha_s$ des impulsions de tension de test ($V_0$, $V_2$, $V_4$, $V_6$, $V_8$, $V_{10}$), l'onde fondamentale représentant la variation temporelle de la contre-tension EMK du stator et la première onde harmonique la variation temporelle de l'inductance du stator du moteur à courant continu (1) ;
   (d) détermination d'une valeur de rapport d'amplitudes $I_{EMK}/I_{Ind}$ des amplitudes $I_{EMK}$ et $I_{Ind}$ de l'onde fondamentale et de la première onde harmonique de la fonction d'approximation $I(\alpha_s)$;
   (e) détermination de la position du rotor en tant qu'angle EMK $\alpha_{EMK}$ à partir de l'argument ($\alpha_s$-$\alpha_{EMK}$) de l'onde fondamentale de la fonction d'approximation $I(\alpha_s)$ et/ou en tant qu'angle d'inductance $\alpha_{Ind}$ à partir de l'argument de la première onde harmonique de la fonction d'approximation $I(\alpha_s)$ en fonction du rapport d'amplitudes $I_{EMK}/I_{Ind}$, l'angle EMK $\alpha_{EMK}$ indiquant le déphasage de la variation sinusoïdale de la contre-tension EMK du stator par rapport à la fonction d'approximation $I(\alpha_s)$ et l'angle d'inductance $\alpha_{Ind}$ indiquant le déphasage de la variation sinusoïdale de l'inductance du stator par rapport à la fonction d'approximation $I(\alpha_s)$.

2. Procédé selon la revendication 1,
**caractérisé en ce que**
en cas d'une valeur A élevée du rapport d'amplitudes $I_{EMK}/I_{Ind}$ avec A≥$a_1$ » 1, l'angle EMK $\alpha_{EMK}$ est déterminé comme position du rotor.

3. Procédé selon l'une des revendications précédentes,
**caractérisé en ce que**
en cas d'une valeur A faible du rapport d'amplitudes $I_{EMK}/I_{Ind}$ avec A ≥ $a_2$ « 1, l'angle d'inductance $\alpha_{Ind}$ est déterminé comme sens du rotor avec une ambiguïté de 180°.

4. Procédé selon l'une des revendications précédentes,
**caractérisé en ce que**
en cas d'une valeur A du rapport d'amplitudes $I_{EMK}/I_{Ind}$ avec $a_2$ < A < $a_1$, où $a_2$ « 1 et $a_1$ » 1, la position du rotor est déterminée à partir de l'angle EMK $a_{EMK}$ et/ou de l'angle d'inductance $\alpha_{Ind}$.

5. Procédé selon la revendication 4,

**caractérisé en ce que**

une valeur est déterminée pour la position du rotor à partir des valeurs pondérées de l'angle EMK $\alpha_{EMK}$ et de l'angle d'inductance $\alpha_{Ind}$, la pondération s'effectuant en fonction des valeurs de l'angle EMK $\alpha_{EMK}$ et de l'angle d'inductance $\alpha_{Ind}$.

6. Procédé selon la revendication 4,
   **caractérisé en ce que**
   la différence de phase spécifique du moteur $\alpha_{EMK\_Ind}$ entre l'angle EMK $\alpha_{EMK}$ et l'angle d'inductance $\alpha_{Ind}$ est déterminée et la valeur de la différence de phase $a_{EMK\_Ind}$ est utilisée pour confirmer la plausibilité des valeurs déterminées à partir de l'angle EMK $\alpha_{EMK}$ et/ou de l'angle d'inductance $\alpha_{Ind}$ pour la position du rotor.

7. Procédé selon l'une des revendications 1 à 3,
   **caractérisé en ce que**
   en cas d'une valeur A du rapport d'amplitudes $I_{EMK}/I_{Ind}$ avec $a_2 < A < a_1$, où $a_2 \ll 1$ et $a_1 \gg 1$, la valeur du minimum absolu ($M_1$) de la fonction d'approximation $I(\alpha_s)$ est utilisée comme position du rotor, dans le cas où la différence de phase $\alpha_{EMK\_Ind}$ spécifique du moteur entre l'angle EMK $\alpha_{EMK}$ et l'angle d'inductance $\alpha_{Ind}$ est déterminée comme étant $+\pi/4$.

8. Procédé selon l'une des revendications 1 à 3,
   **caractérisé en ce que**
   en cas d'une valeur A du rapport d'amplitudes $I_{EMK}/I_{Ind}$ avec $a_2 < A < a_1$, où $a_2 \ll 1$ et $a_1 \gg 1$, la position du rotor est utilisée comme la valeur du minimum absolu de la fonction d'approximation $I(\alpha_s)$, dans le cas où la différence de phase spécifique du moteur $\alpha_{(EMK\_Ind}$ entre l'angle EMK $\alpha_{EMK}$ et l'angle d'inductance $\alpha_{Ind}$ est déterminée comme étant $-\pi/4$.

9. Procédé selon l'une des revendications précédentes,
   **caractérisé en ce que**
   l'angle d'inductance $\alpha_{Ind}$ dans la fonction d'approximation $I(\alpha_s)$ est remplacé par une combinaison sous la forme d'une soustraction entre l'angle EMK $\alpha_{EMK}$ et l'angle d'inductance $\alpha_{Ind}$ avec une valeur de différence $\alpha_{EMK\_Ind}$ déterminée spécifiquement pour le moteur.

10. Procédé selon la revendication 9,
    **caractérisé en ce que**
    l'angle EMK $\alpha_{EMK}$ est déterminé comme position du rotor à partir de l'argument de l'onde fondamentale et de l'argument de la première onde harmonique.

11. Procédé selon l'une des revendications précédentes,
    **caractérisé en ce que**
    la fonction d'approximation $I(\alpha_s)$ est formée à partir d'une superposition d'une onde fondamentale sinusoïdale avec l'amplitude $I_{EMK}$ et de la première onde harmonique associée avec une amplitude $I_{Ind}$ en fonction de la position de phase $\alpha_s$ des impulsions de tension de test ($V_0$, $V_2$, $V_4$, $V_6$, $V_8$, $V_{10}$).

## Fig. 1

## Fig. 2

# Fig. 3

# Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- AT 395487 B
- US 2010141192 A1